Europäisches Patentamt

European Patent Office

Office européen des brevets

(19)

(11) **EP 1 073 110 A1**

(12) **DEMANDE DE BREVET EUROPEEN**

(43) Date de publication:
**31.01.2001 Bulletin 2001/05**

(51) Int. Cl.⁷: **H01L 21/329**, H01L 21/336,
H01L 29/872, H01L 29/78

(21) Numéro de dépôt: **00410086.3**

(22) Date de dépôt: **28.07.2000**

(84) Etats contractants désignés:
**AT BE CH CY DE DK ES FI FR GB GR IE IT LI LU
MC NL PT SE**
Etats d'extension désignés:
**AL LT LV MK RO SI**

(30) Priorité: **28.07.1999 FR 9909985**

(71) Demandeur:
**STMicroelectronics S.A.
94250 Gentilly (FR)**

(72) Inventeur: **Lanois, Frédéric
37100 Tours (FR)**

(74) Mandataire: **de Beaumont, Michel
1, rue Champollion
38000 Grenoble (FR)**

(54) **Procédé de fabrication de composants unipolaires**

(57) L'invention concerne un procédé de fabrication d'un composant unipolaire de type vertical dans un substrat (1) d'un premier type de conductivité, comprenant les étapes suivantes :

former des tranchées dans une couche de silicium (2) du premier type de conductivité ;
revêtir les parois latérales des tranchées d'une couche d'oxyde de silicium (4);

remplir les tranchées de silicium polycristallin (5) du deuxième type de conductivité ; et
effectuer un recuit d'ajustement du niveau de dopage du silicium polycristallin, les dopants en excès étant absorbés par la couche d'oxyde de silicium.

Fig 4

**Description**

La présente invention concerne la fabrication de composants unipolaires sous forme monolithique verticale. La description suivante vise plus particulièrement le cas de composants de type diode Schottky et transistor MOS réalisés sous forme verticale dans des substrats de silicium.

Lors de la fabrication de composants unipolaires, il faut concilier des contraintes opposées. Les composants unipolaires doivent présenter une résistance la plus petite possible quand ils sont à l'état passant (Ron), tout en ayant une tension de claquage la plus élevée possible quand ils sont polarisés en inverse. Minimiser la résistance à l'état passant d'un composant unipolaire impose de minimiser l'épaisseur de la couche la moins dopée et de maximiser le dopage de cette couche. Par contre, obtenir une tenue en tension élevée impose de maximiser l'épaisseur de la couche la moins dopée et de minimiser le dopage de cette couche. Il est donc nécessaire, d'effectuer un compromis entre une tenue en tension élevée et une résistance à l'état passant raisonnable.

Un objet de la présente invention est de proposer un nouveau procédé de fabrication de composants unipolaires de type vertical.

Un autre objet de la présente invention est de proposer un tel procédé de fabrication pour une nouvelle structure de composants unipolaires de type vertical qui présente une tenue en tension améliorée.

Pour atteindre ces objets, la présente invention prévoit un procédé de fabrication d'un composant unipolaire de type vertical dans un substrat d'un premier type de conductivité, comprenant les étapes suivantes :

former des tranchées dans une couche de silicium du premier type de conductivité ;

revêtir les parois latérales des tranchées d 'une couche d'oxyde de silicium ;

remplir les tranchées de silicium polycristallin du deuxième type de conductivité ; et

effectuer un recuit d'ajustement du niveau de dopage du silicium polycristallin, les dopants en excès étant absorbés par la couche d'oxyde de silicium.

La présente invention prévoit également un composant unipolaire de type vertical comportant, dans une couche d'un premier type de conductivité, des tranchées remplies de silicium polycristallin du deuxième type de conductivité, les parois latérales des tranchées étant revêtues d'une couche d'oxyde de silicium et le dopage du silicium polycristallin étant ajusté de façon à être sensiblement égal à celui de la couche du premier type de conductivité.

Selon un mode de réalisation de la présente invention, le composant est une diode Schottky et les tranchées sont formées dans une couche destinée à constituer la cathode de la diode.

Selon un mode de réalisation de la présente invention, le composant est un transistor MOS comprenant une pluralité de cellules de source et les tranchées sont formées au centre de chacune des cellules.

Selon un mode de réalisation de la présente invention, le composant est un transistor MOS comprenant une pluralité de cellules de source et les tranchées sont formées entre les cellules.

Selon un mode de réalisation de la présente invention, le composant est un transistor MOS comprenant une pluralité de cellules de source et les tranchées sont formées au centre des cellules et entre les cellules.

Selon un mode de réalisation de la présente invention, les surfaces des tranchées inter-cellules sont solidaires de métallisations connectées électriquement à des métallisations de source des cellules.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

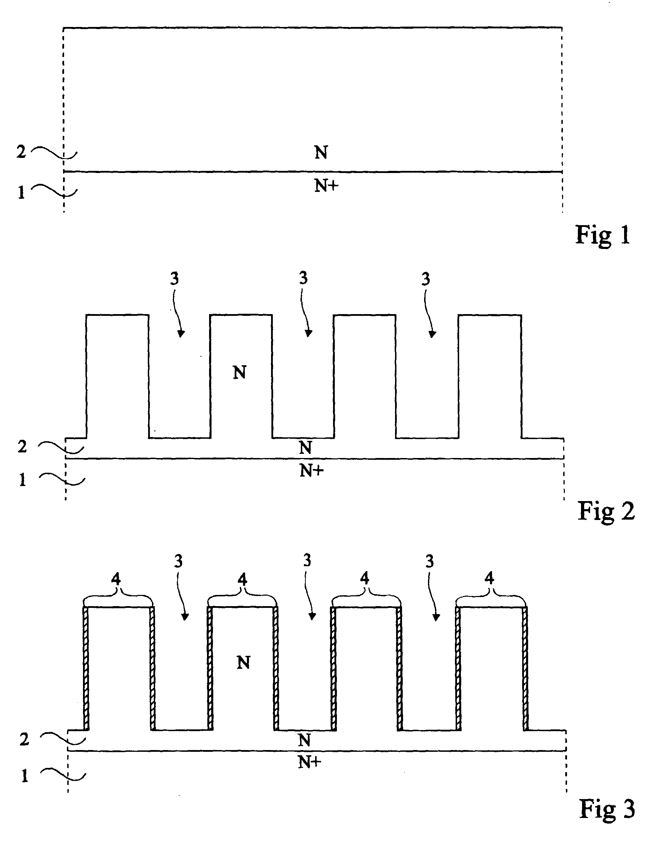

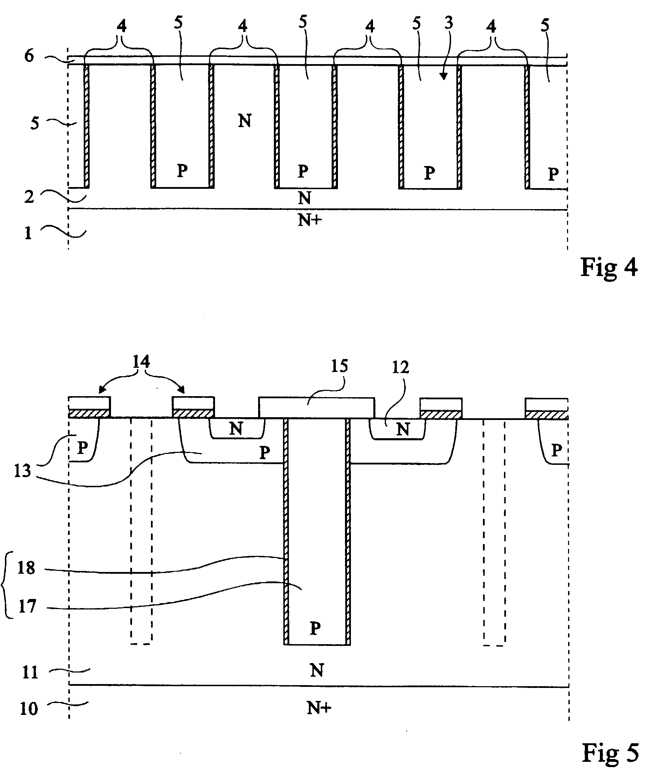

les figures 1 à 4 sont des vues en coupe partielles et schématiques d'une diode Schottky à différentes étapes d'un exemple de mise en oeuvre d'un procédé de fabrication selon la présente invention ; et la figure 5 est une vue en coupe partielle et schématique d'un transistor MOS obtenu à l'aide d'un exemple de mise en oeuvre d'un procédé de fabrication selon la présente invention.

Par souci de clarté, les mêmes éléments ont été désignés par les mêmes références aux différentes figures. De plus, comme cela est habituel dans la représentation des circuits intégrés, les figures ne sont pas tracées à l'échelle.

Un mode de réalisation de la présente invention est décrit ci-après à titre illustratif dans le cas de la fabrication d'une diode Schottky monolithique verticale.

La figure 1 représente l'état d'un substrat de silicium 1 fortement dopé d'un premier type de conductivité, par exemple de type N. Le substrat 1 est destiné à servir de prise de contact de cathode de la diode.

Une couche 2, dopée de type N, mais plus faiblement que le substrat 1, recouvre le substrat 1. La couche 2 résulte par exemple d'une croissance épitaxiale, sur une épaisseur comprise entre 1 et 100 µm. La couche 2, de cathode de la diode Schottky, est destinée à assurer la tenue en tension de cette diode Schottky.

Aux étapes suivantes dont le résultat est illustré en figure 2, on forme selon l'invention des tranchées 3 dans la couche 2. Les tranchées 3 résultent d 'une gravure de la couche 2 à l'aide d'un masque unique. Les tranchées 3 larges, par exemple, d'environ 2 µm et distantes d'environ 2 µm, sont disposées d'une façon qui sera expliquée ci-après. Leur profondeur est inférieure à l'épaisseur de la couche épitaxiale 2.

Aux étapes suivantes dont le résultat est illustré en figure 3, on revêt les parois des tranchées 3 d'une couche isolante mince 4. De préférence, la couche 4 est une couche d'oxyde de silicium d'une épaisseur d'environ 50 nm. Les fonds des tranchées 3 sont maintenus libres. La couche isolante 4 peut résulter d'un dépôt d'oxyde de silicium, ou de la croissance d'un oxyde thermique, suivi d'une gravure anisotrope des parties horizontales de la couche d'oxyde de silicium, tant au sommet de la structure ainsi formée qu'au fond des tranchées 3.

Les avantages liés à la formation de la couche 4 sur les parois des tranchées 3 seront exposés ultérieurement.

Aux étapes suivantes dont le résultat est illustré en figure 4, on remplit les tranchées 3 (figure 3) d'un matériau semiconducteur 5. Avec les techniques actuelles, il est plus simple de prévoir que ce semiconducteur est du silicium polycristallin. Le remplissage des tranchées 3 est assuré, par exemple, par dépôt chimique en phase vapeur (CVD) de silicium polycristallin de type de conductivité opposé à celui de la couche 2 et regravure, par exemple par polissage mécano-chimique. Dans le cas considéré d'une couche épitaxiée 2 de type N, le silicium 5 est dopé de type P par du bore. On notera qu'un tel dopage peut être réalisé soit in-situ, Soit par implantation/diffusion. Cette dernière solution peut être mise en oeuvre du fait que la vitesse de diffusion de dopants dans du silicium polycristallin est très supérieure à la vitesse de diffusion dans du silicium monocristallin. Le dopage est alors effectué avant regravure de la couche supérieure de silicium polycristallin. Le procédé se poursuit par le dépôt d'une couche métallique 6 propre à constituer un contact Schottky avec le silicium 2 de type N.

La présente invention permet d'obtenir de façon simple une diode Schottky à résistance à l'état passant relativement faible pour une tension de claquage relativement élevée.

Cette diode fonctionne de la façon suivante.

En direct, c'est-à-dire quand la métallisation 6 est polarisée positivement par rapport à la couche 1 de type $N^+$, le courant s'écoule depuis la métallisation 6 vers la couche 1 et l'on a une diode Schottky normale entre la couche 6 et les régions N 2. L'existence d'un contact entre la métallisation 6 et la surface supérieure du matériau 5 contenu dans les tranchées 3 n'a pas d'influence sur le fonctionnement du système étant donné que la jonction PN en direct entre le matériau 5 au fond des tranchées 3 et la couche 2 ne peut être rendue passante que si la chute de tension correspondante dépasse 0,6 à 0,7 volts. En pratique, le potentiel au niveau de cette jonction PN est égal à la valeur de la chute de tension Schottky en direct (de l'ordre de 0,3 volts) plus la chute de tension résistive dans la partie de la région N située entre deux rangées. Comme on le verra ci-après, cette région de type N peut avoir une résistance réduite et donc normalement la diode bipolaire correspondant au fond de chacune des tranchées 3 n'a pas d'influence.

En inverse, on peut montrer que, si on appelle S1 et S2 les surfaces respectives en vue de dessus d'une tranchée 3 et d'une région 2 de type N située entre deux tranchées, et si on appelle D1 et D2 les dopages correspondants, dans le cas où S1*D1=S2*D2 , l'ensemble de la structure se comporte comme une couche quasi-intrinsèque. Ainsi, la tension de claquage sera fortement augmentée par rapport à la tension de claquage d'une région dopée, même faiblement. En effet, comme on l'a vu précédemment, moins une couche est dopée plus elle peut supporter des tensions élevées. En pratique, on pourra chercher à avoir S1=S2 et des niveaux de dopage D1=D2 . Alors, le niveau de dopage D2 des régions N peut être nettement plus élevé que précédemment pour une même tension de claquage. Par exemple, si pour une diode classique on cherchait à avoir un niveau de dopage de l'ordre de $10^{15}$ atomes/cm$^3$, on pourra maintenant avoir des niveaux de dopage de l'ordre de quelques $10^{16}$ atomes/cm$^3$ du moment qu'ils s'équilibrent entre les régions P et N.

Ainsi, la diode selon l'invention pourra avoir à la fois, une tension de claquage élevée en inverse et une chute de tension faible en direct.

Il résulte de ce qui précède qu'il est particulièrement important que les niveaux de dopage des régions N et P 2 et 5 soient convenablement choisis (de sorte que comme cela a été indiqué précédemment S1*D1=S2*D2 , ou encore, si S1=S2 , de sorte que D1=D2 ). Ce résultat peut être simplement atteint selon la présente invention grâce à la prévision de la couche d'oxyde de silicium 4 revêtant les parois latérales des tranchées. En effet, après la réalisation des régions N et P, on peut réaliser un test pour vérifier si le résultat recherché est atteint. Sinon, à condition d'avoir pris la précaution de s'assurer que le niveau de dopage de la région P est supérieur ou égal au niveau recherché, on pourra procéder à un recuit d'ajustement de la structure. Lors de la formation antérieure de la couche isolante 4, des dopants de type N (atomes de bore) de la région 2 sont "piégés" dans la couche 4, au voisinage de l'interface entre la région 2 et la couche 4. Au cours du recuit, les dopants de type P (atomes de phosphore) en excès dans le silicium polycristallin contenu dans les tranchées 3 sont absorbés par la couche 4 qui désorbe simultanément dans la région 2 les dopants de type N (atomes de bore) préalablement piégés. Les dopages des tranchées 3 et de la région 2 tendent alors respectivement à décroître et à croître. Il est donc possible de fixer les niveaux de dopage initiaux et les conditions du recuit pour atteindre à la fin de celui-ci l'équilibre D1*S1=D2*S2 décrit précédemment.

A titre d'exemple, en l'absence de tranchées remplies de silicium polycristallin de type P, le dopage de la cathode de la diode serait compris entre 1.10$^{15}$ et

$2.10^{15}$ correspondant à une résistance comprise entre 0,3 et 0,5 $\Omega.mm^2$ pour une tenue en tension d'environ 150 à 200 volts. En présence des tranchées remplies de silicium polycristallin selon l'invention, le dopage de la couche épitaxiée 2 serait de l'ordre de quelques $10^{16}$ atomes/$cm^3$ correspondant à une résistance comprise entre 0,08 et 0,12 $\Omega.mm^2$ pour une tenue en tension d'environ 150 à 200 volts.

Étant donné qu'une diode Schottky selon la présente invention présente une résistance à l'état passant très inférieure à celle d'une diode Schottky classique, elle aura une surface très inférieure en dépit du doublement de surface lié à l'existence des tranchées.

Les principes de la présente invention s'appliquent également à la fabrication sous forme verticale d'autres composants unipolaires, par exemple un transistor MOS vertical comportant une pluralité de cellules de source.

Comme l'illustre la figure 5, une cellule de source d'un transistor MOS vertical est formée dans une couche 11 qui recouvre un substrat de silicium monocristallin 10. La couche 11 est du même type de conductivité que le substrat 10, par exemple de type P, et moins fortement dopée. Les cellules sont constituées d'une région de source 12 dopée de type N formée dans un caisson 13 de type P, d'une structure de grille isolée 14 et d'une métallisation de source 15.

La couche 11 comporte selon la présente invention des tranchées 16 remplies de silicium polycristallin de type P 17 dont les parois sont revêtues d'une couche mince 18 d'oxyde de silicium. Les tranchées 16 remplies de silicium polycristallin 17, après un recuit d'ajustement selon l'invention, présentent un dopage apparent voisin de celui de la couche 11.

Dans le mode de réalisation représenté à la figure 5, les tranchées 16 sont réalisées sensiblement au centre des cellules de source, sous la métallisation de source 15. On notera que les tranchées peuvent alors être solidaires de métallisations connectées électriquement aux métallisations de source 15 du transistor.

Selon un autre mode de réalisation, les tranchées 16 sont formées entre deux cellules de source, par exemple aux emplacements indiqués en pointillés à la figure 5.

Selon un autre mode de réalisation, les deux modes de réalisation précédents sont combinés pour améliorer la tenue en tension. En d'autres termes, un transistor comporte alors des tranchées au centre des cellules de source et des tranchées périphériques formées chacune entre deux telles cellules. Comme dans le mode de réalisation précédent, les tranchées périphériques peuvent alors être solidaires de métallisations connectées électriquement aux métallisations de source 15.

De façon similaire à ce qui a été exposé précédemment dans le cas d'une diode Schottky, la présente invention permet d'obtenir des transistors ayant une plus faible résistance à l'état passant et une plus forte tenue en tension à l'état bloqué.

En effet, le dopage de la couche 11 peut être choisi supérieur à celui de la couche homologue de structures classiques, d'où il résulte une diminution de sa résistance à l'état passant. Cela est possible grâce à l'équilibrage des dopages des tranchées remplies de silicium polycristallin 12 et de la couche 11 qui assure que, en inverse, la tension de claquage est élevée.

Bien entendu, la présente invention est susceptible de diverses variantes et modifications qui apparaîtront à l'homme de l'art. En particulier, la présente invention s'applique à la réalisation sous forme monolithique verticale de tout type de composant unipolaire que ce soit pour réduire sa résistance à l'état passant pour une tenue en tension donnée, ou pour améliorer sa tenue en tension sans augmenter sa résistance à l'état passant.

## Revendications

1.  Procédé de fabrication d'un composant unipolaire de type vertical dans un substrat (1 ; 10) d'un premier type de conductivité, caractérisé en ce qu'il comprend les étapes suivantes :

    former des tranchées (3 ; 16) dans une couche de silicium (2 ; 11) du premier type de conductivité ;
    revêtir les parois latérales des tranchées d'une couche d'oxyde de silicium (4 ; 18);
    remplir les tranchées de silicium polycristallin (5 ; 17) du deuxième type de conductivité ; et
    effectuer un recuit d'ajustement du niveau de dopage du silicium polycristallin, les dopants en excès étant absorbés par la couche d'oxyde de silicium.

2.  Composant unipolaire de type vertical comportant, dans une couche (2 ; 11) d'un premier type de conductivité, des tranchées (3 ; 16) remplies de silicium polycristallin (5 ; 17) du deuxième type de conductivité, caractérisé en ce que les parois latérales des tranchées sont revêtues d'une couche d'oxyde de silicium (4 ; 18) et en ce que le dopage du silicium polycristallin est ajusté de façon à être sensiblement égal à celui de la couche du premier type de conductivité.

3.  Composant selon la revendication 2, constituant une diode Schottky, caractérisé en ce que les tranchées (3) sont formées dans une couche (2) destinée à constituer la cathode de la diode.

4.  Composant selon la revendication 2, constituant un transistor MOS caractérisé en ce qu'il comprend une pluralité de cellules de source et en ce que les tranchées (16) sont formées au centre de chacune des cellules.

**5.** Composant selon la revendication 2, caractérisé en ce que le composant est un transistor MOS comprenant une pluralité de cellules de source et en ce que les tranchées sont formées entre les cellules.

**6.** Composant selon la revendication 2, caractérisé en ce que le composant est un transistor MOS comprenant une pluralité de cellules de source et en ce que les tranchées sont formées au centre des cellules et entre les cellules.

**7.** Composant selon la revendication 5 ou 6, caractérisé en ce que les surfaces des tranchées inter-cellules sont solidaires de métallisations connectées électriquement à des métallisations de source des cellules.

2 〜

1 〜

N

N+

**Fig 1**

3     3     3

N

2 〜

N

N+

1 〜

**Fig 2**

4   3   4   3   4   3   4

N

2 〜

N

N+

1 〜

**Fig 3**

Fig 4

Fig 5

Office européen
des brevets

## RAPPORT DE RECHERCHE EUROPEENNE

Numéro de la demande

EP 00 41 0086

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | CHEN X B ET AL: "Theory of a novel voltage-sustaining layer for power devices" MICROELECTRONICS JOURNAL,GB,MACKINTOSH PUBLICATIONS LTD. LUTON, vol. 29, no. 12, 1 décembre 1998 (1998-12-01), pages 1005-1011, XP004141908 ISSN: 0026-2692 | 1 | H01L21/329 H01L21/336 H01L29/872 H01L29/78 |
| X | * page 1011, colonne de gauche * | 2 | |
| A | DE 197 48 523 A (SIEMENS AG) 12 mai 1999 (1999-05-12) * abrégé; figures 1-7 * | 1 | |
| A | US 5 701 026 A (FUJISHIMA NAOTO ET AL) 23 décembre 1997 (1997-12-23) * figures 15-18 * | 1 | |
| A | DE 197 40 195 A (SIEMENS AG) 25 mars 1999 (1999-03-25) * abrégé; figure 1 * | 2,3 | DOMAINES TECHNIQUES RECHERCHES (Int.Cl.7) |
| A | DE 196 04 043 A (SIEMENS AG) 7 août 1997 (1997-08-07) * figures 1,2 * | 2,4-6 | H01L |
| A | DE 196 11 045 C (SIEMENS AG) 22 mai 1997 (1997-05-22) * figures 1,2 * | 2-7 | |
| A | DE 197 36 981 A (MITSUBISHI ELECTRIC CORP) 20 août 1998 (1998-08-20) * abrégé; figure 1 * | 2,4 | |

Le présent rapport a été établi pour toutes les revendications

| Lieu de la recherche | Date d'achèvement de la recherche | Examinateur |
|---|---|---|
| LA HAYE | 2 novembre 2000 | Gélébart, J |

EPO FORM 1503 03.82 (P04C02)

ANNEXE AU RAPPORT DE RECHERCHE EUROPEENNE
RELATIF A LA DEMANDE DE BREVET EUROPEEN NO.

EP 00 41 0086

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-11-2000

| Document brevet cité au rapport de recherche | | Date de publication | Membre(s) de la famille de brevet(s) | | Date de publication |
|---|---|---|---|---|---|
| DE 19748523 | A | 12-05-1999 | WO<br>EP | 9923704 A<br>1029362 A | 14-05-1999<br>23-08-2000 |
| US 5701026 | A | 23-12-1997 | JP<br>DE<br>US | 8181313 A<br>19539541 A<br>5885878 A | 12-07-1996<br>02-05-1996<br>23-03-1999 |
| DE 19740195 | A | 25-03-1999 | AUCUN | | |
| DE 19604043 | A | 07-08-1997 | WO<br>EP<br>EP<br>JP | 9729518 A<br>1039548 A<br>0879481 A<br>2000504879 T | 14-08-1997<br>27-09-2000<br>25-11-1998<br>18-04-2000 |
| DE 19611045 | C | 22-05-1997 | WO<br>EP<br>US | 9735346 A<br>0888639 A<br>5973360 A | 25-09-1997<br>07-01-1999<br>26-10-1999 |
| DE 19736981 | A | 20-08-1998 | JP<br>US<br>US | 10223896 A<br>6103578 A<br>6040600 A | 21-08-1998<br>15-08-2000<br>21-03-2000 |

EPO FORM P0460

Pour tout renseignement concernant cette annexe : voir Journal Officiel de l'Office européen des brevets, No.12/82